# EUROPÄISCHE PATENTSCHRIFT

(11) **EP 1 525 783 B1**
(45) Veröffentlichungstag und Bekanntmachung des Hinweises auf die Patenterteilung: **12.05.2010**
(21) Anmeldenummer: 03766221.0
(22) Anmeldetag: 18.07.2003
(51) Int. Cl.: H05K 7/20, H05K 5/06

(54) **ELEKTRONIKGEHÄUSE MIT INTEGRIERTEM WÄRMEVERTEILER**
ELECTRONICS HOUSING WITH INTEGRATED THERMAL DISSIPATER
BOITIER ELECTRONIQUE COMPORTANT UN DISSIPATEUR THERMIQUE INTEGRE

(30) Priorität: 31.07.2002 DE 10235047
(43) Veröffentlichungstag der Anmeldung: 27.04.2005
(73) Patentinhaber: Endress + Hauser GmbH + Co. KG, 79689 Maulburg (DE)
(72) Erfinder: BUSCHKE, Ingo, 79689 Maulburg (DE)
(74) Vertreter: Andres, Angelika Maria
(86) Internationale Anmeldenummer: PCT/EP2003/007837
(87) Internationale Veröffentlichungsnummer: WO 2004/014116

(56) Entgegenhaltungen:
- EP-A- 1 182 768
- WO-A-98/08363
- DE-A- 19 910 500

## Beschreibung

Die vorliegende Erfindung betrifft ein Elektronikgehäuse insbesondere ein Elektronikgehäuse für einen Meßumformer.

Bei der Konzeption von elektronischen Geräten ist es wichtig, daß Temperaturspitzen weitgehend vermieden werden, um die Zuverlässigkeit der elektronischen Schaltkreise zu gewährleisten. Insbesondere in explosionsgeschützten Anwendungen ist zu gewährleisten, die Abwärme von elektronischen Bauelementen so abzuführen, daß an keiner Oberfläche eines Gerätes, die Zündtemperatur erreicht wird.

Der Stand der Technik offenbart insbesondere drucktechnisch hergestellte Wärmesenken auf Leiterplatten, wozu Kramer et al. im Referat Nr. 144 der EPC Conference am11. November 1999 in München einen Überblick geben. Auf einer Leiterplatte gedruckte Wärmepfade haben jedoch einen Flächenbedarf, welcher die Integration elektrischer bzw. elektronischer Bauelemente auf der Leiterplatte beschränkt.

Das europäische Patent Nr. 0 920 789 B1 offenbart eine Wärmesenke, welche eine im wesentlichen planare metallische Wärmesenke aufweist, die zwischen zwei dünnen Schichten von elektrisch isolierender und thermisch leitender Vergußmasse mit geringem Abstand parallel zur Leiterplatte angeordnet ist. Die metallische Wärmesenke setzt sich in Ihrem Randbereich in einer wärmeleitenden Zunge fort, welche aus der Vergußmasse herausgeführt wird und mit einer hinreichend großen thermischen Masse verbunden ist, welche seitlich von der Leiterplatte angeordnet ist, wodurch die Abwärme parallel zur Leiterplatte abgeführt wird. Zur festen Verankerung der metallischen Wärmesenke in den dünnen Vergußmasseschichten weist die metallische Wärmesenke Poren auf, welche von der Vergußmasse durchdrungen werden. Die beschriebene Vorrichtung ist insofern nachteilig, als der Querschnitt der Wärmesenke senkrecht zur Richtung des Wärmeflusses sehr gering ist und durch die Poren zusätzlich verringert wird. Zudem ist die Konstruktion der wärmeleitenden Zunge und deren Anschluß an die thermische Masse sehr aufwendig.

Das europäische Patent EP 1 182 768 offenbart eine Vorrichtung gemäß dem Oberbegriff des Anspruchs 1.

Es ist daher die Aufgabe der vorliegenden Erfindung ein Elektronikgehäuse bereitzustellen, welches die beschriebenen Nachteile überwindet.

Grundlage der erfindungsgemäßen Lösung ist die Erwägung daß es nicht darauf ankommt die über eine Gehäusewand abgegebene Wärmemenge zu reduzieren, sondern nur darauf, die Wärme hinreichend homogen über die Fläche der Gehäusewand zu verteilen.

Die Aufgabe wird erfindungsgemäß gelöst durch die Vorrichtung gemäß des unabhängigen Patentanspruchs 1.

Die erfindungsgemäße Vorrichtung umfaßt ein Elektronikgehäuse, welches einen Innenraum definiert; mindestens eine Leiterplatte, die in dem Innenraum angeordnet ist und zumindest auf einer ersten Oberfläche mit elektronischen Bauteilen bestückt ist, wobei die erste Oberfläche einer ersten Wand des Elektronikgehäuses zugewandt und der Innenraum zumindest zwischen der ersten Oberfläche der Leiterplatte und der ersten Wand mit einer Vergußmasse gefüllt ist, wodurch Abwärme der elektronischen Bauteile zu der ersten Wand abgeleitet werden kann; wobei in der Vergußmasse zwischen der Leiterplatte und der ersten Wand ein flächiger Wärmeverteiler eingebettet ist, der mit seiner Vorderseite der ersten Wand und mit seiner Rückseite der Leiterplatte zugewandt ist, und der eine größere spezifische Wärmeleitfähigkeit aufweist als die Vergußmasse, wodurch inhomogene Temperaturverteilungen entlang der Fläche der ersten Wand deutlich abgeschwächt werden.

Der Wärmeverteiler kann beispielsweise eine dünne Metallschicht, -folie, oder -platte, beispielsweise aus Kupfer, sein. Die Stärke der Metallplatte ergibt sich für den Fachmann aus der zu verteilenden Wärmemenge. In den meisten Anwendungsfällen sind Stärken von nicht mehr als etwa 1 mm vorzugsweise nicht mehr als 0,4 mm, besonders bevorzugt zwischen 0,05 mm und 0,2 mm ausreichend.

Der Wärmeverteiler überdeckt vorzugsweise zumindest den Flächenbereich der Leiterplatte in dem jene Bauelemente angeordnet sind, die wesentliche Anteile der auftretenden Abwärme erzeugen.

Sofern die Leiterplatte und die erste Gehäusewand planar sind, ist ein planarer Wärmeverteiler vorzuziehen, der parallel zur Leiterplatte und zur Gehäusewand angeordnet ist. Prinzipiell ist aufgrund des Vorteiles einer möglichen deutlichen Oberflächenvergrößerung auch eine Oberflächenstrukturierung mit strahlförmigen Wellenzügen sinnvoll. Sollte die Gehäusewand eine Wölbung aufweisen, so kann der Wärmeverteiler entweder planar oder gewölbt sein, wobei der Grad der Wölbung vorzugsweise nicht stärker ist als die Wölbung der Gehäusewand.

Als Vergußmasse wird derzeit Silgel bevorzugt, es sind aber auch andere Vergußmassen geeignet, die elektrisch isolierend sind und eine hinreichende Wärmeleitfähigkeit aufweisen.

Das Elektronikgehäuse kann insbesondere das Gehäuse eines Meßumformers sein, wie er beispielsweise in der industriellen Prozeßmeßtechnik zum Einsatz kommt. Besonders geeignet ist die Erfindung für Gehäuse in explosionsgeschützten Anwendungen, da es hier zwingend erforderlich ist, daß die Temperatur der gesamten Gehäuseoberfläche unterhalb von kritischen Grenzwerten bleibt.

Weitere Vorteile und Gesichtspunkte der Erfindung ergeben sich aus den abhängigen Ansprüchen, der nachfolgenden Beschreibung eines Ausführungsbeispiels und den Zeichnungen.

Es zeigt:
- Fig.1:: eine Schnittzeichnung durch ein erfindungsgemäßes Elektronikgehäuse; und
- Fig.2:: die Temperaturverteilung an der Oberfläche eines erfindungsgemäßen Elektronikgehäuses im Vergleich zu einem Elektronikgehäuse nach dem Stand der Technik.

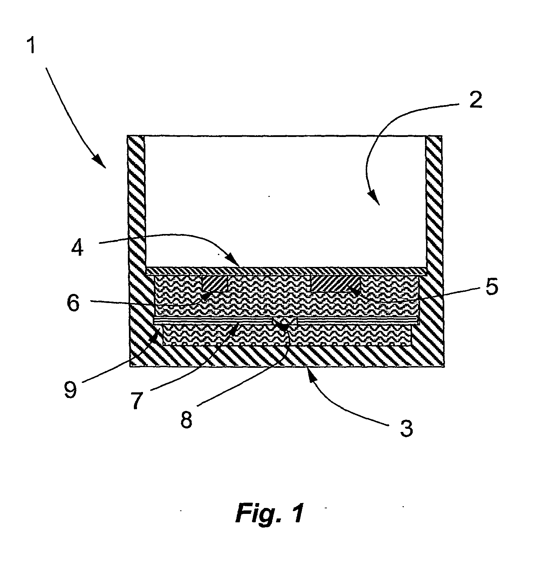

Das in Fig. 1 gezeigte Meßumformergehäuse 1 umschließt einen Innenraum 2 in dem eine Leiterplatte 4 parallel zu einer ersten Wand 3 des Gehäuses 1 angeordnet ist. Die erste Wand kann beispielsweise die Stirnfläche eines zylindrischen Gehäuses 1 sein. Auf einer ersten Oberfläche der Leiterplatte 4, die der ersten Wand zugewandt ist, sind elektronische oder elektrische Bauelemente 5, 6 angeordnet, welche im Betrieb Abwärme erzeugen, die abzuführen ist, um ein Überhitzen der elektronischen Bauteile 5, 6 zu vermeiden.

Zu diesem Zweck ist der Innenraum 2 zumindest in dem Abschnitt zwischen der Leiterplatte 4 und der ersten Wand 3 mit einer Vergußmasse 10, vorzugsweise Silgel, vergossen. In die Vergußmasse ist ein Wärmeverteiler 7 eingebettet, der im wesentlichen parallel zur Leiterplatte 4 angeordnet ist. Die Position des Wärmeverteilers 7 beabstandet zur Leiterplatte und zur ersten Wand 3 ist bei dieser Ausführungsform durch Anschläge 9 definiert, an denen der Wärmeverteiler in seinem Randbereich anliegt.

Der Wärmeverteiler 7 ist bevorzugt eine metallische Schicht, insbesondere eine metallische Folie oder Platte. Bei der derzeit bevorzugten Ausführungsform wird eine Kupferplatte mit einer Stärke von 0,2 mm eingesetzt.

Die optionale Öffnung 8 in dem Wärmeverteiler 7 ermöglicht den Durchtritt der Vergußmasse, was die mechanische Verankerung des Wärmeverteilers 7 verbessert.

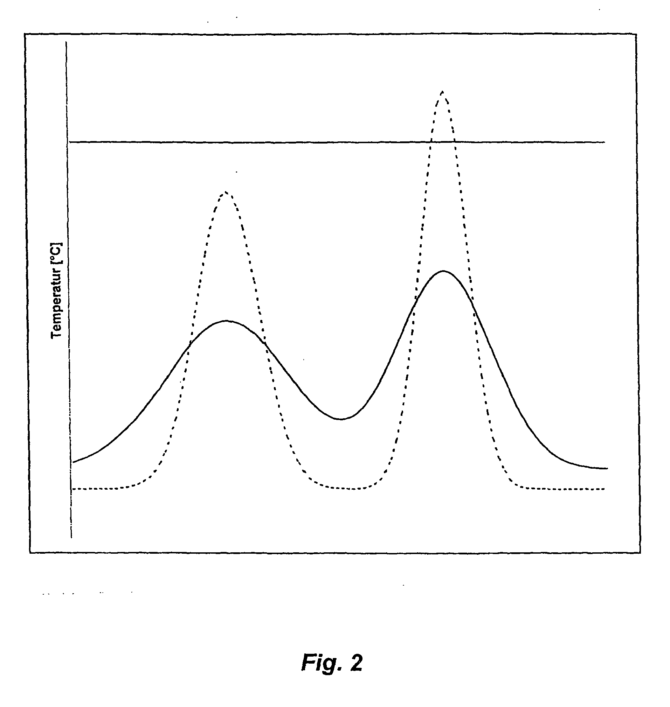

Die Wirkung des Wärmeverteilers wird nun anhand des Diagramms in Fig. 2 erläutert, welche schematisch den Verlauf der Temperatur an der äußeren Oberfläche der Gehäusewand 3 entlang einer Linie zeigt, deren Projektion auf die Ebene der Leiterplatte über die elektronischen Bauelemente 5, 6 verläuft.
Die gestrichelte Linie zeigt den Temperaturverlauf ohne einen Wärmeverteiler in der Vergußmasse und die durchgezogene Linie zeigt den Temperaturverlauf mit einem Wärmeverteiler in der Vergußmasse. Durch den Wärmeverteiler werden die lokalen Temperaturmaxima verbreitert, und die Spitzenwerte werden deutlich herabgesetzt, so daß kritische Grenzwerte deutlich unterschritten werden können. Auf die Angabe von Einheiten wurde verzichtet, da der exakte Verlauf der Temperaturlinie ohnehin von der Geometrie der jeweiligen Anordnung abhängt. Als Richtwert kann die Spitzentemperatur von etwa 75°C auf 45° abgesenkt werden.

Damit sind deutliche Abstände zu den kritischen Temperaturen explosinsgefährdeter Prozesse zu erzielen, die erhöhte Sicherheitsreserven auch beim Überhitzen von Bauteilen nach deren Ausfall ermöglichen.

## Patentansprüche

1. Vorrichtung mit
einem Elektronikgehäuse (1), welches einen Innenraum (2) definiert; mindestens einer Leiterplatte (4), die in dem Innenraum angeordnet ist und zumindest auf einer ersten Oberfläche mit elektronischen Bauteilen (5, 6) bestückt ist, wobei die erste Oberfläche einer ersten Wand (3) des Elektronikgehäuses (1) zugewandt und der Innenraum (2) zumindest zwischen der ersten Oberfläche der Leiterplatte (4) und der ersten Wand (3) mit einer Vergußmasse (10) gefüllt ist, wodurch Abwärme der elektronischen Bauteile (5, 6) zu der ersten Wand (3) abgeleitet werden kann; **dadurch gekennzeichnet, daß**
in der Vergußmasse zwischen der Leiterplatte (4) und der ersten Wand (5) ein flächiger Wärmeverteiler eingebettet ist, der mit seiner Vorderseite der ersten Wand (3) und mit seiner Rückseite der Leiterplatte (4) zugewandt ist, und der eine größere spezifische Wärmeleitfähigkeit aufweist als die Vergußmasse, wodurch inhomogene Temperaturverteilungen entlang der Fläche (3) der ersten Wand abgeschwächt werden.

2. Vorrichtung nach Anspruch 1,wobei der Wärmeverteiler (7) eine metallische oder keramische Schicht, Folie umfaßt.

3. Vorrichtung nach Anspruch 2, wobei der Wärmeverteiler Kupfer oder Aluminiumnitrid aufweist.

4. Vorrichtung nach Anspruch 2 oder 3, wobei der Wärmeverteiler (7) eine Stärke der Metallplatte oder Keramikplatte von nicht mehr als 1 mm bevorzugt nicht mehr als 0,4 mm, und besonders bevorzugt zwischen 0,05 mm und 0,2 mm aufweist.

5. Vorrichtung nach einem der Ansprüche 1 bis 4 wobei der Wärmeverteiler (7) im wesentlichen planar ist.

6. Vorrichtung nach einem der Ansprüche 1 bis 4, wobei die erste Wand (3) gewölbt ist, und wobei der Wärmeverteiler (7) entweder planar oder gewölbt ist, und der Grad der Wölbung nicht stärker ist als die Wölbung der Wand (3).

7. Vorrichtung nach einem der Ansprüche 1 bis 4, wobei der Wärmeverteiler ein Wellenmuster, insbesondete ein strahlenförmiges Wellenmuster aufweist.

8. Vorrichtung nach einem der vorhergenenden Ansprüche wobei die Vorrichtung ein Meßumformer, insbesondere für explosionsgeschützte Anwendungen ist.

## Claims

1. Unit with:
an electronic housing (1) which defines an interior chamber (2);
at least one printed circuit board (4), which is arranged in the interior chamber and is fitted with electronic components (5, 6) on at least one surface, whereby the first surface is facing a first panel (3) of the electronic housing (1) and the interior chamber (2) is filled with a potting compound (10) at least between the first surface of the PCB (4) and the first panel (3), through which heat from the electronic components (5, 6) can be directed to the first wall (3), **characterized in that**:
a flat heat spreader is embedded in the potting compound between the PCB (4) and the first panel (5). The front side of said heat spreader faces the first panel (3) and its rear side faces the PCB (4). The heat spreader exhibits a higher specific thermal conductivity than the potting compound, as a result of which heterogeneous temperature distributions are attenuated along the surface (3) of the first panel.

2. Unit as per Claim 1, whereby the heat spreader (7) comprises a metal or ceramic layer, foil.

3. Unit as per Claim 2, whereby the heat spreader exhibits copper or aluminum nitride.

4. Unit as per Claim 2 or 3, whereby the heat spreader (7) exhibits a metal or ceramic plate thickness of not more than 1mm, preferably not more than 0.4mm and most preferably between 0.05mm and 0.2 mm.

5. Unit as per one of the Claims 1 to 4, whereby the heat spreader is essentially planar.

6. Unit as per one of the Claims 1 to 4, whereby the first panel (3) is curved, and whereby the heat spreader (7) is either planar or curved, and the degree of curvature is not greater than the curvature of the panel (3).

7. Unit as per one of the Claims 1 to 4, whereby the heat spreader exhibits a wave pattern, particularly a radial wave pattern.

8. Unit as per one of the previous Claims, whereby the unit is a transmitter particularly for explosion-protected applications.

## Revendications

1. Dispositif avec un
boîtier électronique (1), lequel définit un espace intérieur (2) ;
au moins une carte de circuit imprimé (4), qui est disposée dans l'espace intérieur et est équipée de composants électroniques (5, 6) au moins sur une première surface, la première surface faisant face à une première paroi (3) du boîtier électronique (1) et l'espace intérieur (2) étant rempli au moins entre la première surface de la carte de circuit imprimé (4) et la première paroi (3) avec une masse de remplissage (10), laquelle permet d'évacuer la chaleur dissipée par les composants électroniques (5, 6) vers la première paroi (3) ; **caractérisé en ce**
**qu'**est encastré, dans la masse de remplissage, entre la carte de circuit imprimé (4) et la première paroi (3), un répartiteur de chaleur, dont la face avant fait face à la première paroi (3) et la face arrière fait face à la carte de circuit imprimé (4), et qui présente une conductivité thermique spécifique supérieure à la masse de remplissage, ce qui permet d'atténuer les répartitions hétérogènes de la température le long de la surface (3) de la première paroi.

2. Dispositif selon la revendication 1, pour lequel le répartiteur de chaleur (7) comprend un film / une couche métallique ou céramique.

3. Dispositif selon la revendication 2, pour lequel le répartiteur de chaleur (7) comporte du cuivre ou du nitrure d'aluminium.

4. Dispositif selon la revendication 2 ou 3, pour lequel le répartiteur de chaleur (7) comprend une épaisseur de plaque métallique ou de plaque céramique d'un maximum de 1 mm, de préférence d'un maximum de 0,4 mm et particulièrement de préférence entre 0,05 et 0,2 mm.

5. Dispositif selon la revendication 1 à 4, pour lequel le répartiteur de chaleur (7) est pour l'essentiel plan.

6. Dispositif selon la revendication 1 à 4, pour lequel la première paroi (3) est convexe et pour lequel le répartiteur de chaleur (7) est soit plan, soit convexe, et le degré de convexité n'est pas supérieur à la convexité de la paroi (3).

7. Dispositif selon la revendication 1 à 4, pour lequel le répartiteur de chaleur présente un aspect ondulatoire, notamment un aspect ondulatoire radial.

8. Dispositif selon l'une des revendications précédentes, pour lequel le dispositif est un transmetteur, notamment prévu pour les applications antidéflagrantes.
